(19) Europäisches Patentamt
European Patent Office
Office européen des brevets

(11) **EP 2 461 346 B1**

(12) **EUROPÄISCHE PATENTSCHRIFT**

(45) Veröffentlichungstag und Bekanntmachung des Hinweises auf die Patenterteilung:
**02.05.2018 Patentblatt 2018/18**

(51) Int Cl.:
**H01J 37/147** *(2006.01)*    **H01J 37/28** *(2006.01)*

(21) Anmeldenummer: **11191531.0**

(22) Anmeldetag: **01.12.2011**

(54) **Teilchenstrahlgerät mit Ablenksystem**

Particle beam apparatus with deflection system

Appareil à faisceau de particules doté d'un système de déviation

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.12.2010 DE 102010053194**

(43) Veröffentlichungstag der Anmeldung:
**06.06.2012 Patentblatt 2012/23**

(73) Patentinhaber:
• **Carl Zeiss Microscopy GmbH**
  **07745 Jena (DE)**
• **Carl Zeiss Microscopy Limited**
  **Cambridge**
  **CB1 3JS (GB)**

(72) Erfinder:
• **Preikszas, Dirk**
  **73447 Oberkochen (DE)**
• **Hayn, Armin Heinz**
  **Essex CB11 3AG (GB)**

(74) Vertreter: **Carl Zeiss AG - Patentabteilung**
**Carl-Zeiss-Strasse 22**
**73447 Oberkochen (DE)**

(56) Entgegenhaltungen:
**DD-A1- 135 311        US-A1- 2007 075 262**
**US-A1- 2008 142 723**

**Beschreibung**

Die vorliegende Erfindung betrifft ein Teilchenstrahlgerät mit einem ersten und einem zweiten Ablenksystem zur Ablenkung des Teilchenstrahls in einer Objektebene. Die vorliegende Erfindung betrifft insbesondere ein Teilchenstrahlgerät in Form eines Elektronenmikroskops, beispielsweise eines Rasterelektronenmikroskops oder eines Transmissionselektronenmikroskops, eines Ionenmikroskops oder eines Elektronenstrahl- oder Ionenstrahllithografiesystems. Die vorliegende Erfindung betrifft außerdem ein Verfahren zum Betrieb eines entsprechenden Teilchenstrahlgeräts.

Teilchenstrahlgeräte der oben genannten Art weisen häufig Ablenksysteme auf, mit deren Hilfe der Teilchenstrahl in der Objektebene im Wesentlichen senkrecht zur Ausbreitungsrichtung des Teilchenstrahls ausgelenkt werden kann. Durch Detektion der Wechselwirkungsprodukte des Teilchenstrahls mit einer in der Objektebene angeordneten Oberfläche einer Probe in Abhängigkeit von der Auslenkung des Teilchenstrahls kann dann ein Bild der Probenoberfläche erzeugt werden. Alternativ oder ergänzend dazu kann ein durch den Teilchenstrahl aktivierbares Prozessgas der Probenoberfläche zugeführt werden, mit dessen Hilfe dann in den Bereichen, in denen der Teilchenstrahl auf die Probenoberfläche auftrifft, die Probenoberfläche lokal geätzt wird oder Material aus dem Prozessgas auf der Probenoberfläche abgeschieden wird.

Darüber hinaus ist es möglich, eine vorher auf die Probenoberfläche aufgebrachte teilchenempfindliche Schicht mit Hilfe des Teilchenstrahls lokal zu belichten und anschließend mit weiteren Verfahren zu strukturieren.

Der Teilchenstrahl wird in einem Teilchenstrahlerzeuger erzeugt und durch eine Objektivlinse in der Objektebene fokussiert. Der dort fokussierte Teilchenstrahl wird häufig und auch nachfolgend auch als Teilchensonde bezeichnet.

Die Bewegung der Teilchensonde, erfolgt in der Regel durch eine Auslenkung des Teilchenstrahls durch ein Magnetfeld, das mit Hilfe von Spulen erzeugt wird, und/oder mit Hilfe eines elektrischen Felds, das mit Hilfe von Elektroden erzeugt wird. Die Spulen von magnetischen Ablenksystemen sind häufig als Luftspulen ausgebildet, die außerhalb des Vakuumrohres angeordnet sein können und die eine hinreichend schnelle Auslenkung des Teilchenstrahls bzw. der Teilchensonde ermöglichen.

Zur Fokussierung des Teilchenstrahls bzw. zur Erzeugung der Teilchensonde kann eine Objektivlinse eingesetzt sein, die ebenfalls durch magnetische und/oder elektrische Felder gebildet wird. Die Objektivlinse wird üblicherweise mit einer möglichst kurzen Brennweite betrieben, um eine möglichst gute Auflösung zu erreichen. Aufgrund der kleinen Brennweite der Objektivlinse ist der Arbeitsabstand zwischen der Objektivlinse und der Objektebene sehr klein und beträgt in der Regel nur einige Millimeter bis wenige Zentimeter. Aufgrund des geringen Bauraums zwischen der Objektivlinse und der Objektebene werden die Ablenksysteme in der Regel quellenseitig der Objektivlinse angeordnet.

Wenn für die Auslenkung des Teilchenstrahls ein einziges einfaches Ablenksystem quellenseitig oder innerhalb der Objektivlinse eingesetzt wird, verläuft der Teilchenstrahl abhängig von der Stärke der Auslenkung des Teilchenstrahls unterschiedlich schief durch die Objektivlinse, wodurch von der Auslenkung des Teilchenstrahls abhängige Bildfehler entstehen. Um derartige vom Ablenkwinkel abhängige Bildfehler zu vermeiden oder gering zu halten, werden häufig sogenannte Doppelablenksysteme eingesetzt, die zwei einzelne Ablenksysteme aufweisen, die in Richtung der optischen Achse des Teilchenstrahls bzw. der Objektivlinse mit Abstand von einander angeordnet sind. Durch geeignete Kombination der Auslenkungen von zwei seriell hintereinander angeordneten Ablenksystemen lässt sich die Lage eines virtuellen Kipppunkts entlang der teilchenoptischen Achse verschieben, wobei die Auslenkung virtuell wie durch eine Kippung um diesen Kipppunkt erzeugt erscheint. Dadurch ist es beispielsweise möglich, einen virtuellen Kipppunkt für die Auslenkung in einer Ebene zu erzeugen, die zu einer Minimierung der von der Stärke der Auslenkung abhängigen zusätzlichen Bildfehler führt, auch wenn die entsprechende Ebene für die Anordnung eines Ablenksystems unzugänglich ist.

Der Abgleich der Ablenkfelder der beiden seriell hintereinander entlang der optischen Achse angeordneten Ablenksysteme und der für die Erzeugung der Ablenkfelder erforderlichen Ströme und/oder Spannungen erfolgt üblicherweise bei der Justierung des Teilchenstrahlgeräts in Abhängigkeit von der konkret eingesetzten Objektivlinse. Der Abgleich erfolgt dabei in der Regel derart, dass die durch die Auslenkung erzeugten zusätzlichen Bildfehler, die dann von der Stärke der Auslenkung abhängig sind, minimal sind. Die bei der Justierung des Teilchenstrahlgeräts entsprechend gewonnen Abgleichdaten werden dann gespeichert und beim nachfolgenden Betrieb des Teilchenstrahlgeräts nicht mehr verändert.

Aus der US 6,809,322 ist ein Teilchenstrahlgerät bekannt, das drei seriell hintereinander angeordnete Ablenksysteme aufweist. Durch die drei seriell hintereinander angeordneten Ablenksysteme, soll erreicht werden, dass das mit dem Teilchenstrahl in der Objektebene maximal abgerasterte Bildfeld nicht oder nur möglichst gering durch eine zwischen der Objektivlinse und der Objektebene angeordnete Druckstufenblende beschnitten wird. Aus US 2008/0142723 A1 ist ein weiteres Teilchenstrahlgerät bekannt, das drei seriell hintereinander angeordnete Ablenksysteme aufweist.

Bei einigen Teilchenstrahlgeräten der Anmelderin ist es möglich, diese in einem sogenannten "Fischaugen-Modus" zu betreiben. Bei diesem "Fischaugen-Modus" erzeugen zwei seriell hintereinander angeordnete Ablenksysteme Ablenkungen in derselben Richtung. Der Teilchenstrahl verläuft dann bei einer Auslenkung die Objektivlinse sehr stark außeraxial, was zu starken außeraxialen Aberationen führt. Das in diesem "Fischaugen-Modus" aufgezeichnete Bild, weist daher sehr starke vom Ablenkwinkel abhängige Fehler auf, ermöglicht aber gleichzeitig ein sehr großes Übersichtsbild der gesamten Probe, bzw. des gesamten Innenraums der Probenkammer zu erzeugen. Erreicht wird dieser "Fischaugen-Modus" dadurch, dass beim Umschalten in diesen "Fischaugen-Modus" die Polarität des Ablenksystems, das näher an der Objektivlinse angeordnet ist, gegenüber dem Normalbetrieb umgeschaltete wird.

Bei einigen anderen Teilchenstrahlgeräten der Anmelderin ist es möglich, diese in einem sogenannten "Kippraster-Modus" zu betreiben. Bei diesem "Kippraster-Modus" erzeugen zwei seriell hintereinander angeordnete Ablenksysteme Ablenkungen in derselben Richtung, aber in einem etwas anderen Verhältnis. Der Teilchenstrahl verläuft dann bei einer Auslenkung in der Objektivlinse noch außeraxial, wird dann von der Objektivlinse wieder zu dem Punkt auf der Probe gelenkt, der auch ohne Auslenkung vom Teilchenstrahl getroffen wird. Die Auslenkung in den beiden Ablenksystemen erfolg also so, wie wenn der ausgelenkte Teilchenstrahl von der Teilchenquelle kommen würde. Damit lassen sich Messungen zum Kristallgefüge der Probe bewerkstelligen, da sich je nach Orientierung des auftreffenden Teilchenstrahls andere Wechselwirkungsprodukte ergeben. Erreicht wird dieser "Kippraster-Modus" dadurch, dass beim Umschalten in diesen "Kippraster-Modus" zu dem Ablenksystem, das näher an der Objektivlinse angeordnet ist, gegenüber dem Normalbetrieb eine geeignete Widerstand-Drossel-Kombination parallel geschaltet wird.

Ziel der vorliegenden Erfindung ist es, ein Teilchenstrahlgerät anzugeben, das eine Optimierung der Strahlablenkung für unterschiedliche Anwendungen oder Betriebsbedingungen ermöglicht. Dieses Ziel wird durch ein Teilchenstrahlgerät mit den Merkmalen der Ansprüche 1 und 8 sowie durch ein Verfahren zum Betrieb eines Teilchenstrahlgeräts mit den Merkmalen des Anspruchs 17 gelöst. Vorteilhafte Ausgestaltungen der Erfindung ergeben sich aus den Merkmalen der abhängigen Patentansprüche.

Ein Teilchenstrahlgerät nach der Erfindung weist einen Teilchenstrahlerzeuger auf. Der Teilchenstrahlerzeuger kann beispielsweise eine Elektronenquelle wie einen thermischen Wolframemitter, einen $LAB_6$-Emitter oder einen Schottky-Emitter oder einen Ionen-Emitter, wie eine Gasfeldionisationsquelle aufweisen. Das Teilchenstrahlgerät kann weiterhin eine Objektivlinse zum Fokussieren des vom Teilchenstrahlerzeuger erzeugten Teilchenstrahls in einer Objektebene aufweisen. Die Objektivlinse definiert dabei eine optische Achse, um die die Objektivlinse - bis auf Fertigungstoleranzen - rotationssymmetrisch ausgebildet ist.

Das Teilchenstrahlgerät kann ein erstes Ablenksystem und ein zweites Ablenksystem zur Ablenkung des Teilchenstrahls in der Objektebene aufweisen, wobei das erste und das zweite Ablenksystem seriell hintereinander entlang der optischen Achse mit einem Abstand zwischen dem ersten und zweiten Ablenksystem angeordnet sind. In einem ersten Betriebsmodus kann das erste Ablenksystem ein erstes Ablenkfeld und das zweite Ablenksystem ein zweites Ablenkfeld erzeugen. Das erste und das zweite Ablenkfeld haben eine erste Winkelorientierung zueinander und können so zueinander ausgerichtet sein, dass Sie gemeinsam in der Objektebene eine Auslenkung des Teilchenstrahls in einer ersten Richtung bewirken. In einem zweiten Betriebsmodus des Teilchenstrahlgeräts erzeugt das erste Ablenksystem ein drittes Ablenkfeld und das zweite Ablenksystem ein viertes Ablenkfeld, wobei das dritte und das vierte Ablenkfeld eine zweite Winkelorientierung zueinander aufweisen, die unterschiedlich ist zu der ersten Winkelorientierung zwischen dem ersten Ablenkfeld und dem zweiten Ablenkfeld im ersten Betriebsmodus. Auch im zweiten Betriebsmodus bewirken das dritte und das vierte Ablenkfeld zusammen in der Objektebene eine Auslenkung des Teilchenstrahls in derselben Richtung, in der die Auslenkung des Teilchenstrahls im ersten Betriebsmodus erfolgt.

Der Erfindung liegt die Erkenntnis zugrunde, dass es nützlich ist, wenn für unterschiedliche Betriebsbedingungen des Teilchenstrahlgeräts unterschiedliche Winkelorientierungen der Ablenkfelder des ersten und des zweiten Ablenksystems zueinander einstellbar sind. Dadurch kann je nach Anwendungsbedingung die Winkelorientierung der Ablenkfelder zueinander so eingestellt werden, dass die bei der jeweiligen Anwendung am stärksten störenden Aberrationen vermieden oder kompensiert werden können.

Um unterschiedliche Winkelorientierungen der Ablenkfelder zueinander im ersten Betriebsmodus und im zweiten Betriebsmodus zu erreichen, sollte das dritte Ablenkfeld vom ersten Ablenkfeld und/oder das vierte Ablenkfeld, insbesondere in der Winkelorientierung, vom zweiten Ablenkfeld abweichen.

In einem ersten Betriebsmodus kann die erste Winkelorientierung so gewählt sein, dass der außeraxiale Komafehler bei der Fokussierung des Teilchenstrahls durch die Objektivlinse minimal ist. Alternativ kann in dem ersten Betriebsmodus die Winkelorientierung des ersten und des zweiten Ablenkfelds zueinander so gewählt sein, dass die gemeinsame, trübende Wirkung von außeraxialem Komafehler und außeraxialer Dispersion bei der Fokussierung des Teilchenstrahls durch die Objektivlinse minimal ist. Eine Minimierung des außeraxialen Komafehlers oder eine Minimierung der gemeinsamen, trübenden Wirkung von außeraxialem Komafehler und außeraxialer Dispersion ist insbesondere in einem Betriebsmodus vorteilhaft, in dem Bilder mit sehr hoher Ortsauflösung (durch Korrektur der axialen Bildfehler erreichbar) oder mit hoher Pixelzahl aufgenommen werden sollen oder Strukturen mit sehr hoher Ortsauflösung oder großer Pixelzahl geschrieben werden sollen.

In einem zweiten Betriebsmodus kann die zweite Winkelorientierung so gewählt sein, dass die Verzeichnung bei der Fokussierung des Teilchenstrahls durch die Objektivlinse minimal ist. Eine Winkelorientierung mit minimaler Verzeichnung ist dann vorteilhaft, wenn Bilder mit maximalem Bildfeld aufgenommen werden sollen oder Strukturen mit maximaler Größe geschrieben werden sollen. Wenn bei einem solchen Teilchenstrahlsystem zwischen einem Betriebsmodus, der ein maximales Bildfeld ermöglicht, und einem Betriebsmodus, der eine maximale Pixelzahl ermöglicht, gewechselt werden soll, erfolgt auch eine Änderung der Winkelorientierung der Ablenkfelder des ersten und des zweiten Ablenksystems zueinander.

Alternativ oder ergänzend kann in einem Betriebsmodus die erste Winkelorientierung so gewählt sein, dass die Beschneidung des Bildfelds durch einen Engpass im Strahlrohr bei der Fokussierung des Teilchenstrahls durch die Objektivlinse minimal wird. Ein solcher Betriebsmodus ist insbesondere dann nützlich, wenn das Teilchenstrahlgerät auch in einem sogenannten "Variable Pressure" Bereich betrieben werden kann, bei dem in der Probenkammer ein relativ hoher Gasdruck herrscht. Für den Betrieb des Teilchenstrahlgeräts im "Variable Pressure" Modus ist in der Regel eine Druckstufenblende zwischen der Objektivlinse und der Objektebene erforderlich, damit im Strahlrohr trotz des relativ hohen Drucks in der Probenkammer ein gutes Vakuum aufrecht erhalten werden kann. Da die Druckstufenblende nur eine kleine Öffnung aufweist, tritt im "Variable Pressure" Betrieb häufig eine Beschneidung des Bildfelds auf. Durch geeignete Wahl der Winkelorientierung der Ablenkfelder zueinander kann erreicht werden, dass der Teilchenstrahl unabhängig vom Ablenkwinkel relativ nah an der teilchenoptischen Achse die Öffnung der Druckstufenblende passiert, so dass kein oder nur ein geringfügiger Beschnitt des Bildfeldes auftritt.

Unterschiedliche Winkelorientierungen der Ablenkfelder lassen sich dadurch realisieren, dass das erste Ablenksystem und das zweite Ablenksystem als gekreuzte Ablenksysteme ausgebildet sind, die also eine Strahlauslenkung in zwei nicht zueinander parallele, vorzugsweise zueinander senkrechte, Richtungen ermöglichen. Die Ansteuerung für die Ablenkfelder in einem gekreuzten Ablenksystem oder in beiden gekreuzten Ablenksystemen kann in Abhängigkeit vom eingestellten Betriebsmodus unterschiedlich gemischt werden.

Alternativ oder ergänzend ist es möglich, im Strahlengang drei Strahlablenksysteme seriell hintereinander anzuordnen, wobei mindestens eines der drei Strahlablenksysteme gegenüber den beiden anderen Strahlablenksystemen um die optische Achse verdreht angeordnet ist. Weiterhin ist es natürlich auch möglich, dass alle drei Ablenksysteme relativ zueinander um die optische Achse verdreht zueinander angeordnet sind. Der Drehwinkel zwischen den Orientierungen der Ablenksysteme sollte dabei mindestens 5 Grad, vorzugsweise mehr als 10 Grad, und wiederum vorzugsweise mehr als 20 Grad betragen, damit die verschiedenen für eine Optimierung der Verläufe der Teilchenstrahlbahnen durch das Objektiv erforderlichen gesamten Winkelorientierungen möglich sind.

Die Änderung der Winkelorientierung der Ablenkfelder zueinander kann bei einem Teilchenstrahlsystem mit drei Ablenksystemen, die seriell hintereinander angeordnet sind, dadurch erfolgen, dass je nach Betriebsmodus eines der Ablenksysteme zugeschaltete bzw. eines der Ablenksysteme ausgeschaltet wird. Auch ein Umpolen eines Ablenksystems oder ein Verschalten mit passiven elektrischen Bauteilen (Widerstand, Spule, Kondensator) ist dazu möglich.

Die Änderung der Winkelorientierung zwischen den Ablenkfeldern kann manuell oder auch automatisch erfolgen. Beispielsweise ist es möglich, dass die Winkelorientierung automatisch geändert wird, wenn zwischen Betriebsmodi mit unterschiedlichen Maximalauslenkungen in der Objektebene gewechselt wird, was bei einem Rasterelektronenmikroskop einem Wechsel der Vergrößerung entspricht. Alternativ ist es möglich, die Winkelorientierung der Ablenkfelder zueinander zu variieren, wenn die Beleuchtungsapertur des Teilchenstrahls geändert wird. Beispielsweise ist es möglich bei einer Beleuchtung mit einer hohen Apertur eine Winkelorientierung der Ablenkfelder einzustellen, bei der die Objektivlinse unabhängig vom Ablenkwinkel eine niedrige sphärische Aberration aufweist. Hierdurch kann erreicht werden, dass Bilder mit einer maximalen räumlichen Auflösung aufgenommen oder Strukturen mit einer maximalen Auflösung geschrieben werden, das heißt, dass eine Teilchensonde mit einem möglichst kleinen Durchmesser erreicht wird. Unter Umständen wird man bei dieser Winkelorientierung ein gewisses Mehr an Verzeichnung an den Rändern des Bildfeldes zulassen, um einen zu starken negativen Effekt der sphärischen Aberration zuvermeiden. Wird dagegen das Teilchenstrahlgerät in einem Betriebsmodus betrieben, bei dem der Teilchenstrahl nur eine geringe Beleuchtungsapertur aufweist und demzufolge die sphärische Aberration der Objektivlinse keinen oder nur einen geringen Einfluss auf die Größe der Teilchensonde hat, wird auf eine Winkelorientierung umgestellt, bei der die Verzeichnung auch bei maximalen Ablenkwinkeln minimal ist.

Nachfolgend werden Einzelheiten der Erfindung anhand der in den Figuren dargestellten Ausführungsbeispiele näher beschrieben. Im Einzelnen zeigen:

Figur 1: die Prinzipskizze eines Teilchenstrahlgeräts in Form eines Rasterelektronenmikroskops im Schnitt;

Figuren 2a und 2b: Diagramme der Ablenkfelder in zwei unterschiedlichen Betriebsmodi;

Figur 3: eine vereinfachte perspektivische Darstellung eines Teilchenstrahlsystems,

Figur 4: ein Blockschaltbild zur Erläuterung der Ansteuerung der Strahlablenksysteme im Teilchenstrahlgerät gemäß Figur 3 bei analoger Signalmischung;

Figur 5: ein Blockschaltbild für die Signalgenerierung der Ablenksysteme beim Teilchenstrahlsystem gemäß Figur 3 bei digitaler Signalmischung;

Figur 6 : eine vereinfachte perspektivische Darstellung eines Teilchenstrahlgeräts mit zwei gekreuzten Ablenksystemen, die relativ zueinander um die optische Achse der Objektivlinse verdreht sind;

Figur 7: eine vereinfachte perspektivische Darstellung eines Teilchenstrahlgeräts mit drei seriell hintereinander angeordneten Strahlablenksystemen, von denen ein Ablenksystem relativ zu den beiden anderen Strahlablenksystemen um die optische Achse verdreht ist;

Figur 8: eine vereinfachte perspektivische Darstellung einer Ausführungsform mit drei seriell hintereinander angeordneten Ablenksystemen, die alle gegeneinander um die optische Achse verdreht sind;

Figuren 9a und 9b: Diagramme des radialen Abstands der Trajektorien des Teilchenstrahls bei zwei bzw. drei Ablenksystemen.

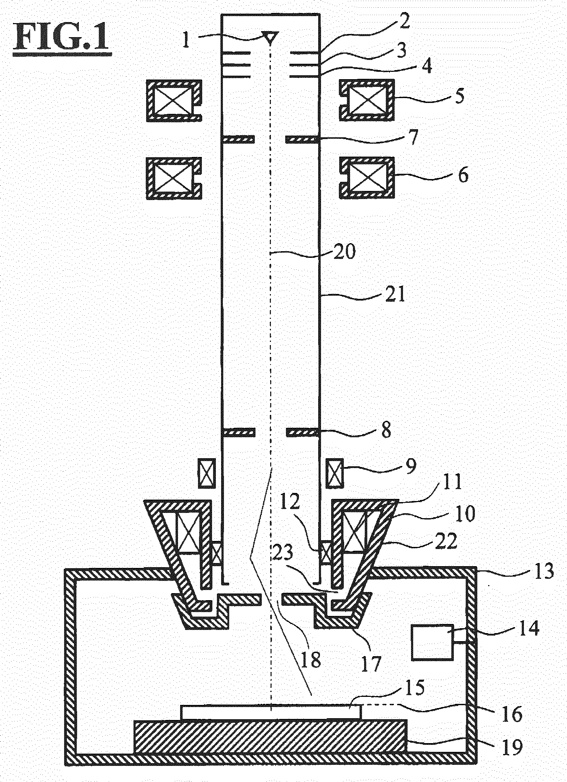

Das Teilchenstrahlgerät in Figur 1 weist einen Strahlerzeuger mit einer Elektronenquelle (1), einer Extraktionselektrode (2), einer Steuerelektrode (3) und einer Anode (4) auf. Die Anode (4) bildet dabei gleichzeitig das quellenseitige Ende des Strahlführungsrohres (21). Die Elektronenquelle kann als thermischer Feldemitter ausgebildet sein. Die Elektronenquelle kann jedoch ebenso als thermischer Wolframemitter oder $LAB_6$ -Emitter ausgebildet sein.

Elektronen, die aus der Kathode (1) austreten, bilden einen Primärelektronenstrahl. Die Elektronen werden aufgrund einer Potenzialdifferenz zwischen dem Elektronenemitter (1) und der Anode (4) auf Anodenpotenzial beschleunigt. Das Anodenpotenzial liegt üblicherweise 1-30 kV positiv gegenüber dem Kathodenpotenzial, sodass die Elektronen eine kinetische Energie im Bereich zwischen 1 keV und 30 keV aufweisen.

Am Strahlführungsrohr (21) folgen in Ausbreitungsrichtung der aus dem Teilchenstrahlerzeuger austretenden Elektronen zwei seriell hintereinander angeordnete Kondensorlinsen (5), (6). Zwischen den Kondensorlinsen (5), (6) ist eine Aperturblende (7) im Strahlführungsrohr angeordnet. Durch unterschiedliche Kombinationen der Erregungen der Kondensorlinsen (5) und (6) kann die Apertur des aus der probenseitigen Kondensorlinse (6) austretenden Elektronenstrahls variiert werden.

Im weiteren Verlauf des Teilchenstrahls vom Teilchenstrahlerzeuger zur Objektebene (16) folgen ein quellenseitiges Ablenksystem (9), ein probenseitiges Ablenksystem (12) und eine Objektivlinse (10). Die Objektivlinse (10) ist im hier dargestellten Ausführungsbeispiel als Magnetlinse ausgebildet und weist einen Polschuh (22) mit einem Polschuhspalt (23) auf. In dem Polschuh (22) ist eine Ringspule (11) zur Erzeugung des Magnetfelds der Objektivlinse angeordnet. Die Hauptebene der Objektivlinse (10) liegt in etwa auf der Höhe des Polschuhspalts (23), sodass - obwohl das probenseitige Ablenksystem (12) physisch in der Nähe des Polschuhspalts (23) der Objektivlinse (10) angeordnet ist - dieses Ablenksystem (12) ebenso, wie das quellenseitige Ablenksystem (9) quellenseitig vor der Hauptebene der Objektivlinse (10) angeordnet ist.

Beide Strahlablenksysteme (9), (12) sind gekreuzte Strahlablenksysteme, das heißt jedes der beiden Strahlablenksysteme (9) und (12) kann den Teilchenstrahl in zwei nicht zueinander parallelen Richtungen, die senkrecht zur Richtung der optischen Achse (20) stehen, auslenken. In dem in der Figur 1 dargestellten Fall sind beide Strahlablenksysteme als magnetische Strahlablenksysteme ausgebildet und weisen dementsprechend jeweils vier um die optische Achse des Teilchenstrahlgeräts angeordnete Luftspulen auf. Es ist jedoch auch denkbar, die Strahlablenksysteme oder zumindest eines der beiden Strahlablenksysteme als elektrostatisches Strahlablenksystem auszubilden. In diesem Fall würde das betreffende elektrostatisch ausgebildete Strahlablenksystem vier Elektroden aufweisen, die mit unterschiedlichen elektrostatischen Potenzialen beaufschlagbar sind.

Die Objektivlinse (10) ragt von oben durch eine Öffnung in den Innenraum einer Probenkammer (13) hinein. In der Probenkammer (13) kann auf einem Objekttisch (19) eine Probe (15) aufgenommen werden.

Durch die Objektivlinse (10) wird der vom Strahlerzeuger (1) erzeugte und mit Hilfe der Kondensorlinsen (5), (6) geformte Teilchenstrahl in einer Objektebene (16) fokussiert. In der Objektebene (16) entsteht demzufolge eine feine Elektronensonde. Der Abstand der Objektebene (16) von der Unterkante der Objektivlinse (10) bzw. der Unterkante des Polschuhs (22) der Objektivlinse (10) ist dabei nicht fest, sondern kann durch Variation der Erregung der Objektivlinse entlang der optischen Achse (20) variiert werden. Durch unterschiedliche Erregungen der beiden Ablenksysteme (9), (12) kann der Teilchenstrahl in der Objektebene (16) senkrecht zur optischen Achse (20) ausgelenkt werden, sodass durch unterschiedliche Auslenkungen des Teilchenstrahls die in der Objektebene (16) positionierte Oberfläche der Probe (15) abgerastert werden kann.

In der Probenkammer (13) kann ein Detektor (14) angeordnet sein, mit dem Wechselwirkungsprodukte des Teilchenstrahls mit der Probe (15) bzw. der Oberfläche der Probe (15) detektiert werden können. Alternativ oder ergänzend dazu kann ein weiterer Detektor (8) im Strahlführungsrohr angeordnet sein, mit dessen Hilfe Wechselwirkungsprodukte des Teilchenstrahls mit der Probe (15) oder der Oberfläche der Probe (15), die in das Strahlführungsrohr (21) gelangen, detektiert werden können. Durch Aufnahme der mit einem oder beiden der Detektoren (8), (14) detektierten Signale in Abhängigkeit von der Position, in der der Teilchenstrahl auf die Oberfläche der Probe (15) auftrifft, kann ein Bild der Oberfläche der Probe (15) erzeugt werden. Zusätzlich ist es möglich, durch ein hier nicht dargestelltes Gaseinlasssystem ein spezielles Precursor-Gas oder Prozessgas in die Probenkammer (13) einzulassen, das durch den Teilchenstrahl an der Stelle, an der der Teilchenstrahl auf die Oberfläche der Probe (15) auftrifft, chemisch aktiviert werden kann. Mit Hilfe eines solchen Precursor-Gases ist dann ein lokales elektronenstrahlinduziertes Ätzen der Probe (15) oder eine lokale, durch den Elektronenstrahl induzierte Abscheidung von Material auf der Oberfläche der Probe (15) möglich.

In der Figur 1 weiterhin dargestellt ist ein Druckstufenblendenhalter (17), der an dem Polschuh (22) der Objektivlinse, der in die Probenkammer (13) hineinragt, aufnehmbar ist. Der Druckstufenblendenhalter (17) weist eine Blende mit einer kleinen Blendenöffnung (18) auf. Weitere Druckstufenblenden sind innerhalb des Strahlführungsrohrs (21) angeordnet und in der Figur 1 nicht dargestellt. Ebenfalls in der Figur 1 nicht dargestellt sind die Vakuumpumpen, die zur Erzeugung und Aufrechterhaltung des für den Betrieb des Teilchenstrahlgeräts erforderlichen Vakuums innerhalb des Strahlführungsrohrs (21) und der Probenkammer (13) erforderlich sind.

Wenn das Teilchenstrahlgerät mit Hochvakuum in der Probenkammer (13) betrieben wird, ist die Druckstufenblende (17) nicht erforderlich und kann demzufolge vom Polschuh (22) der Objektivlinse (10) abmontiert werden. Wie man anhand der Figur 1 erkennt, kann in diesem Betriebsmodus ein großes Bildfeld in der Objektebene (16) abgerastert werden, ohne dass ein mechanischer Beschnitt des Teilchenstrahls erfolgt.

Soll hingegen das Teilchenstrahlgerät mit relativ hohem Druck in der Probenkammer (Drücke im Bereich etwa 1 bis 3000 Pa) betrieben werden, muss der Druckstufenblendenhalter (17) am Polschuh (22) der Objektivlinse montiert sein, damit innerhalb des Strahlführungsrohrs (21) durch differenzielles Pumpen trotz des höheren Drucks in der Probenkammer (13) ein hinreichend gutes Vakuum aufrecht erhalten werden kann. Bei montiertem Druckstufenblendenhalter (17) führt der Rand der Öffnung (18) innerhalb der Druckstufenblende (17) zu einem Beschnitt des in der Objektebene (16) abrasterbaren Bildfelds.

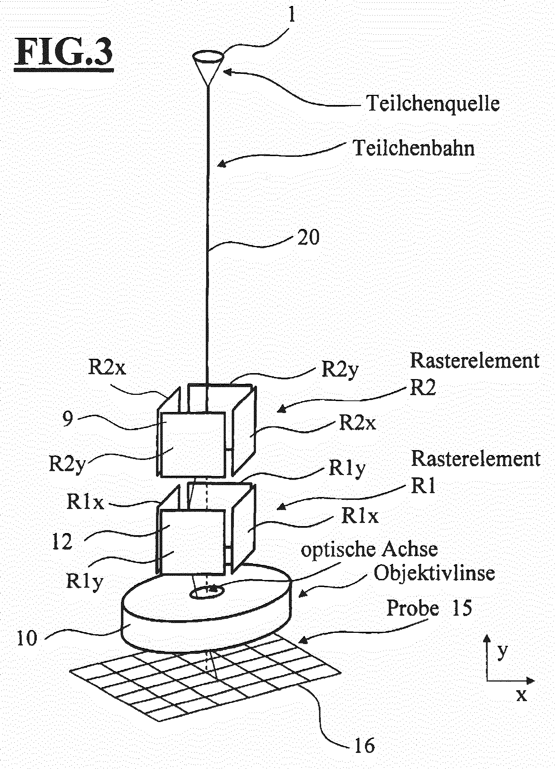

In der Figur 3 ist das Teilchenstrahlsystem aus Figur 1 noch einmal vereinfacht und perspektivisch dargestellt. Die in der Figur 3 dargestellten Komponenten sind dabei mit denselben Bezugszeichen versehen wie in der Figur 1. Wie man der Figur 3 entnimmt, weist jedes der beiden Ablenksysteme (9, 12) jeweils vier um die optische Achse verteilte Ablenkelemente auf. So weist das probenseitige Ablenksystem (12) zwei sich bezüglich der optischen Achse (20) gegenüberstehende Ablenkelemente $R_{1X}$ auf, die eine Ablenkung in einer ersten Raumrichtung (X-Richtung) bewirken. Zusätzlich weist das probenseitige Ablenksystem (12) zwei sich bezüglich der optischen Achse (20) gegenüberstehende Ablenkelemente $R_{1Y}$ auf, bei deren Erregung eine Ablenkung des Teilchenstrahls in Richtung einer zweiten Raumrichtung (Y-Richtung) erfolgt, die idealer Weise zur ersten Raumrichtung (X-Richtung) senkrecht steht, aber auf jeden Fall nicht parallel oder antiparallel zur ersten Raumrichtung steht. Entsprechend weist auch das quellenseitige Ablenksystem (9) vier Ablenkelemente $R_{2X}$, $R_{2Y}$ auf, von denen sich wiederum zwei parallel gegenüberstehen und die beiden Anderen um annähernd 90 Grad versetzt um die optische Achse (20) angeordnet sind. Auch beim zweiten Ablenksystem (9) bewirkt eine Erregung der Ablenkelemente $R_{2X}$ eine Auslenkung des Teilchenstrahls in der ersten Richtung (X-Richtung) und eine Erregung des dazu im Wesentlichen senkrechten Paares an Ablenkelementen $R_{2Y}$ eine Auslenkung des Teilchenstrahls im Wesentlichen senkrecht zur ersten Richtung.

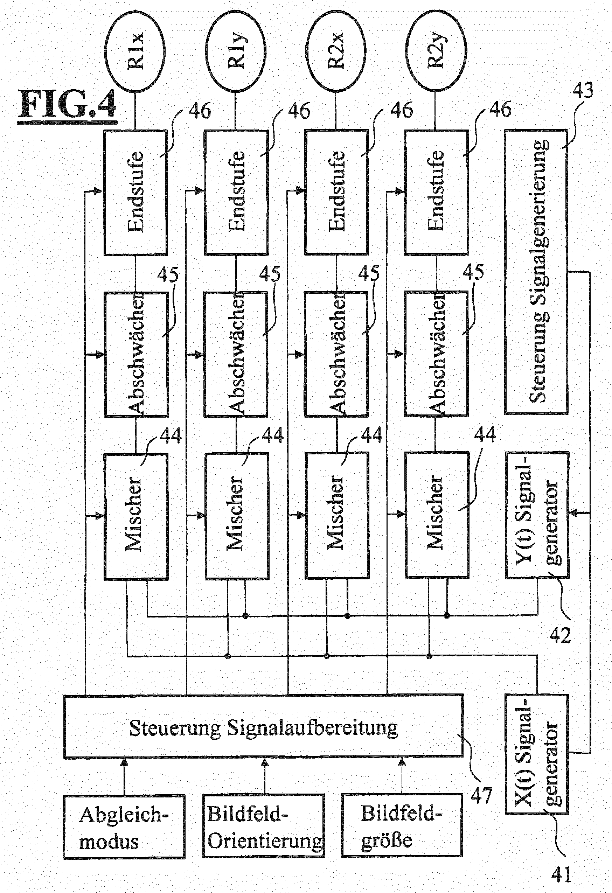

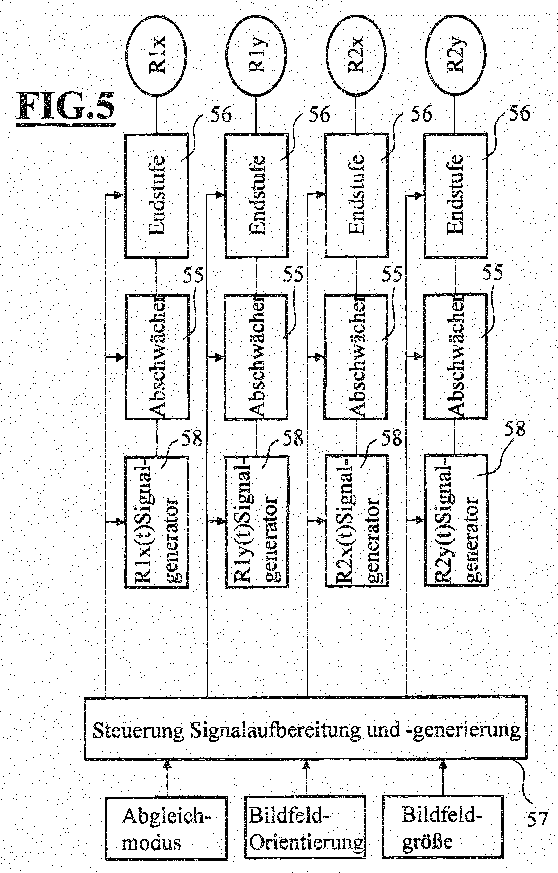

Für die Ansteuerung der Ablenksysteme (9) und (12) kann eine Schaltung vorgesehen sein, wie sie in den Figuren 4 und 5 dargestellt ist. Die Steuerschaltung weist für jedes Ablenkelement $R_{1X}$, $R_{1Y}$, $R_{2X}$, $R_{2Y}$ der beiden Ablenksysteme (9, 12) eine Serienschaltung aus einem Mischer (44), einem Abschwächer (45), der die Höhe des Ausgangssignals einer Endstufe (46) und damit die Bildfeldgröße beeinflusst, und einer Endstufe (46) auf. Entsprechend besteht die Schaltung aus vier parallelen Schaltungen aus Mischer (44), Abschwächer (45) und Endstufe (46). Jedem der vier Mischer (44) ist als Eingang das Ausgangssignal eines X(t)-Signalgenerators (41) und eines Y(t)-Signalgenerators (42) zugeführt. Die von den beiden Signalgeneratoren (41), (42) erzeugten Ausgangssignale wiederum werden von einer Signalgenerierungsteuerung (43) bestimmt. Je nach dem, welche Signale von einer Signalaufbereitungssteuerung (47) bereitgestellt werden, werden von den Mischern (44) unterschiedliche Linearkombinationen der von den beiden Signalgeneratoren (41, 42) bereitgestellten Signale erzeugt und nach Abschwächung durch einen Abschwächer (45) und Nachverstärkung durch eine Endstufe (46) auf das jeweils zugeordnete Ablenkelement $R_{1X}$, $R_{1Y}$, $R_{2X}$, $R_{2Y}$ ausgegeben. Eingangsparameter für die Signalaufbereitungssteuerung (47) sind dabei der Abgleichmodus, die Bildfeldorientierung und die Bildfeldgröße. Je nach dem gerade durch die Eingangsparameter, den Abgleichmodus, die Bildfeldorientierung und die Bildfeldgröße vordefinierten Betriebsmodus werden von den Mischern (44) Signale erzeugt, die nach Abschwächung und Endverstärkung mit Hilfe der Ablenkelemente $R_{1X}$, $R_{1Y}$ $R_{2X}$, $R_{2Y}$ Ablenkfelder erzeugen, die unterschiedliche Winkelorientierungen zueinander aufweisen.

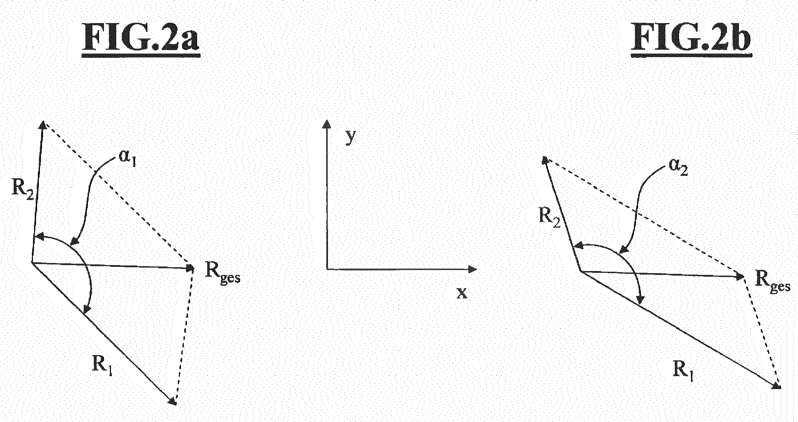

In einem ersten Betriebsmodus, der in Figur 2a dargestellt ist, ist das vom probenseitigen Ablenksystem (12) erzeugte Ablenkfeld mit ($R_1$) und das vom quellenseitigen Ablenksystem (9) erzeugte Ablenkfeld mit ($R_2$) bezeichnet. Die beiden Ablenkfelder ($R_1$, $R_2$) weisen unterschiedliche Winkelorientierungen auf, das heißt, sie schließen einen

Winkel $\alpha_1$ ein. In Summe bewirken die beiden seriell aufeinanderfolgenden Ablenkfelder ($R_1$) und ($R_2$) zusammen mit der Wirkung des Objektives (10) eine Ablenkung des Teilchenstrahls in der Objektebene (16) in Richtung einer ersten Richtung ($R_{Ges}$). Die Richtung ($R_{Ges}$) stimmt dabei mit der X-Richtung des zwischen den Figuren 2a und 2b dargestellten Koordinatensystems überein, das heißt durch die beiden Ablenkfelder ($R_1$) und ($R_2$) erfolgt insgesamt eine Strahlauslenkung des Teilchenstrahls in der X-Richtung.

In einem zweiten Betriebsmodus, der in der Figur 2b dargestellt ist, ist wiederum das vom probenseitigen Ablenksystem (12) erzeugte Ablenkfeld mit ($R_1$) und das vom quellenseitigen Ablenksystem (9) erzeugte Ablenkfeld mit ($R_2$) bezeichnet. Gegenüber den entsprechenden Feldrichtungen der Ablenkfelder im Betriebsmodus in der Figur 2a weisen die Ablenkfelder eine gegenüber dem ersten Betriebsmodus geänderte Winkelorientierung auf, das heißt der Winkel $\alpha_2$ zwischen den beiden Feldrichtungen ($R_1$) und ($R_2$) weicht vom Winkel $\alpha_1$ im ersten Betriebsmodus ab. Dennoch bewirkt das seriell aufeinanderfolgende Ablenken durch die Ablenkfelder ($R_1$) und ($R_2$) des Teilchenstrahls zusammen mit der Wirkung der Objektivlinse (10), dass der Teilchenstrahl in der Objektebene (16) wiederum in dieselbe Ablenkrichtung ($R_{Ges}$) abgelenkt wird, wie in dem ersten Betriebsmodus der in der Figur 2a dargestellt ist. Das bedeutet, dass auch in dem in der Figur 2b dargestellten Betriebsmodus die Auslenkung des Teilchenstrahls in der Objektebene (16) in X-Richtung in dem zwischen den Figuren 2a und 2b dargestellten Koordinatensystem erfolgt.

Mathematisch lässt sich das zuvor Beschriebene wie folgt beschreiben:

In den Signalgeneratoren (41, 42) werden zeitabhängige Signale für die Auslenkung $X = X(t)$ und $Y = Y(t)$ erzeugt. Aufgrund der in den Mischern (44) aus den Ausgangssignalen der Signalgeneratoren (41, 42) erzeugten Linearkombinationen und der nachfolgenden Abschwächung und Nachverstärkung in den Endstufen (46) gilt für die Ablenkfelder $R_{1X}$, $R_{1Y}$, $R_{2X}$, $R_{2Y}$ folgender Gleichungszusammenhang:

$$R_{1x} = C_1 \cdot X(t) + C_2 \cdot Y(t) \tag{1}$$

$$R_{1y} = C_3 \cdot X(t) + C_4 \cdot Y(t) \tag{2}$$

$$R_{2x} = C_5 \cdot X(t) + C_6 \cdot Y(t) \tag{3}$$

$$R_{2y} = C_7 \cdot X(t) + C_8 \cdot Y(t) \tag{4}$$

Die Wirkung der Faktoren $C_1$-$C_8$ lässt sich besser verstehen, wenn man die vorstehenden Gleichungen wie folgt umformuliert:

$$R_{1x} = B \cdot K_{1x} \cdot [X(t) \cdot \cos(\beta + \varphi_{1x}) - Y(t) \cdot \sin(\beta + \varphi_{1x})] \tag{5}$$

$$R_{1y} = B \cdot K_{1y} \cdot [X(t) \cdot \sin(\beta + \varphi_{1y}) + Y(t) \cdot \cos(\beta + \varphi_{1y})] \tag{6}$$

$$R_{2x} = B \cdot A \cdot K_{2x} \cdot [X(t) \cdot \cos(\beta + \alpha + \varphi_{2x}) - Y(t) \cdot \sin(\beta + \alpha + \varphi_{2x})] \tag{7}$$

$$R_{2y} = B \cdot A \cdot K_{2y} \cdot [X(t) \cdot \sin(\beta + \alpha + \varphi_{2y}) + Y(t) \cdot \cos(\beta + \alpha + \varphi_{2y})] \tag{8}$$

Die Konstanten $K_{ij}$ und $\varphi_{ij}$ sind Kalibrierfaktoren, die die effektive Abweichung eines Rasterelements (zum Beispiel eines Spulenpaares oder eines Elektrodenpaares) von der idealen Geometrie beschreiben. Im Idealfall wären $K_{ij} = 1$ und $\varphi_{ij} = 0$. Für die Ablenkfelder $R_{1X}$, $R_{1Y}$, $R_{2X}$ und $R_{2Y}$ ergeben sich dann mit der vorstehenden Vereinfachung die folgenden Gleichungen:

$$R_{1x} = B \cdot [X(t) \cdot \cos(\beta) - Y(t) \cdot \sin(\beta)] \qquad (9)$$

$$R_{1y} = B \cdot [X(t) \cdot \sin(\beta) + Y(t) \cdot \cos(\beta)] \qquad (10)$$

$$R_{2x} = B \cdot A \cdot [X(t) \cdot \cos(\beta + \alpha) - Y(t) \cdot \sin(\beta + \alpha)] \qquad (11)$$

$$R_{2y} = B \cdot A \cdot [X(t) \cdot \sin(\beta + \alpha) + Y(t) \cdot \cos(\beta + \alpha)] \qquad (12)$$

Mit der Größe B lässt sich die Größe des in der Objektebene abgerasterten Feldes und mit der Größe $\beta$ lässt sich die Orientierung des Bildfeldes in der Objektebene ändern. Mit den Größen A und $\alpha$ kann ein Abgleich in Stärke und Orientierung zwischen dem probenseitigen und dem quellenseitigen Ablenksystem stattfinden. Dabei beschreibt $\alpha$ die Winkelorientierungen des ersten und des zweiten Ablenkfelds im probenseitigen Ablenksystem (12) und im quellenseitigen Ablenksystem (9) zu einander. Beim Umschalten zwischen den verschiedenen Betriebsmodi wird durch die Bildung der Linearkombinationen in den Mischern (44) der Winkel $\alpha$, der die Winkelorientierung zwischen den Ablenkfelder beschreibt, geändert. Bei einigen Ausführungsformen der Erfindung kann auch die Größe A geändert werden, also die relative Stärke der Ablenkfelder zwischen dem probenseitigen und dem quellenseitigen Ablenksystem.

Nicht unerwähnt sollte bleiben, dass sich bei einer Änderung von A oder $\alpha$ gleichzeitig auch die Größe und/oder die Orientierung des in der Objektebene abgerasterten Bildfelds ändert. Soll bei einer Änderung der Größe A oder der Winkelorientierung $\alpha$ die Größe und die Orientierung des Bildfelds konstant gehalten werden, ist gleichzeitig eine Anpassung des Faktors B und des Winkels $\beta$ erforderlich.

Um die verschiedenen Signale für die Ablenkelemente entsprechend den Gleichungen 9 -12 zu generieren und aufzubereiten, gehen in die Signalaufbereitung (47) in der Figur 4 neben dem Parameter "Abgleichmodus" auch die Parameter "Bildfeldorientierung" und "Bildfeldgröße" ein. Dabei wirkt der Steuerparameter "Bildfeldgröße" auf den Faktor B, der Steuerparameter "Bildfeldorientierung" auf den Winkel $\beta$ und der Abgleichmodus auf den Faktor A und die Winkelorientierung $\alpha$, indirekt aber auch noch auf die Größen B und $\beta$, wenn das Bildfeld konstant bleiben soll.

Die Endstufen (46) kann man in der Regel zwischen mehreren Spannungsbereichen bei Ablenkelektroden bzw. Strombereichen bei Ablenkspulen umschalten. Die Endstufen tragen damit zu einer Abschwächung des Signals bei. Dieses ist notwendig um den großen erforderlichen Dynamikbereich hinsichtlich der Bildfeldgröße ohne Qualitätsverlust abdecken zu können.

Entsprechend den durch die Gleichungen 9 -12 bestimmten Zusammenhängen konfiguriert die Steuerungssignalaufbereitung (47) die analogen Mischer (44), die Abschwächer (45) und die Endstufen (46). Dabei wirkt die Steuergröße "Bildfeldgröße" mit dem Faktor B im Wesentlichen auf die Abschwächer (45) und die Endstufen (46), während die Winkelwerte $\alpha$ und $\beta$ ausschließlich auf die Mischer (44) wirken. Den Faktor A kann man sowohl in den Mischern (44) als auch in den Abschwächern (45) und den Endstufen (46) in die Signalaufbereitung integrieren.

In der alternativen Ausführungsform entsprechend der Figur 5 werden die bereits digital in der Steuerung Signalaufbereitung und Generierung (57) gemischten Funktionen X(t) und Y(t) direkt in den Signalgeneratoren (58) erzeugt. Dabei ist für jedes Ablenkelement $R_{1X}$, $R_{1Y}$, $R_{2X}$, $R_{2Y}$ ein eigener Signalgenerator (58) vorhanden. Die Steuergröße B wirkt bei dieser Anordnung analog zu der Ausführungsform in Figur 4 auf die Abschwächer (55) und die Endstufen (56), um den großen Dynamikbereich der Bildfeldgröße ohne Qualitätsverlust abdecken zu können.

Die digitale Ausführung gemäß der Figur 5 hat gegenüber der analogen Signalaufbereitung entsprechend der Figur 4 den Nachteil, dass vier anstelle von zwei Signalgeneratoren erforderlich sind. Dafür liefert die Ausführungsform in Figur 5 den Vorteil, dass die beim analogen Mischen unvermeidbar auftretenden Ungenauigkeiten vermieden sind.

Es sei noch darauf hingewiesen, dass in den Figuren 4 und 5 die zusätzlich noch erforderlichen Einrichtungen zum elektrischen Verschieben des Bildfelds in der Objektebene nicht dargestellt sind.

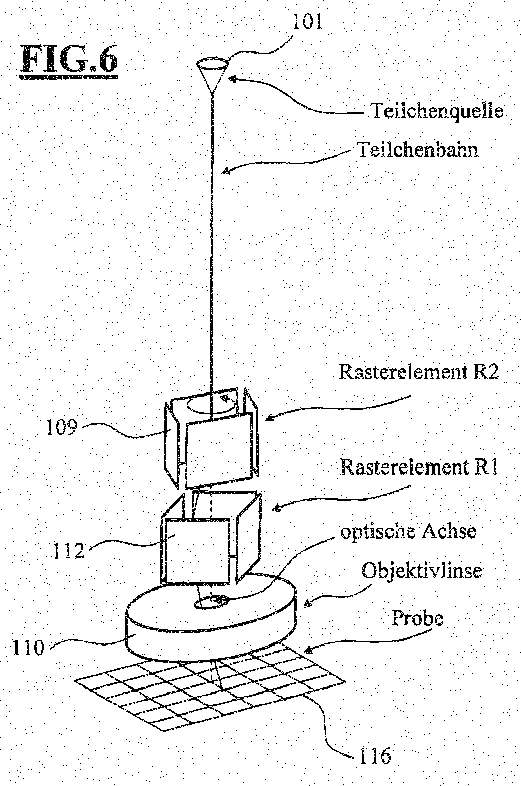

Durch die Bildung der Linearkombinationen der von den Signalgeneratoren (41) und (42) in der Figur 4 erzeugten Signale in den Mischern (44) bzw. in der Anordnung nach Figur 5 durch die Steuerung Signalaufbereitung und Generierung (57) werden in den Ablenksystemen Ablenkfelder erzeugt, die denen von zwei seriell hintereinander geschalteten Ablenksystemen (109), (112) entsprechen, die zueinander um die optische Achse verdreht sind, wie dieses in der Figur 6 dargestellt ist. Der Möglichkeit, unterschiedliche Linearkombinationen zu bilden, würde einer Anordnung entsprechen, bei der beide Ablenksysteme (109), (112) frei um die optische Achse drehbar sind, während das Objektiv (110) ortsfest bleiben. Der Teilchenstrahlerzeuger ist in der Figur 6 mit (101) bezeichnet.

Je nach Anwendung ist es sinnvoll, für den Faktor A und die Winkelorientierung $\alpha$ etwas unterschiedliche Werte zu wählen:

Bei der Erzeugung von Übersichtsbildern mit geringer Vergrößerung ist die Verzeichnung des Bildes dominant. Man unterscheidet eine kissen- bzw. tonnenförmige Verzeichnung von einer S-förmigen Verzeichnung. Bei einer rein elektrostatischen Objektivlinse tritt nur die kissen- bzw. tonnenförmige Verzeichnung auf. Diese lässt sich allein durch geeignete Wahl der Größe A beseitigen. Bei Teilchenstrahlgeräten mit magnetischer Objektivlinse führt die Lamor-Drehung der Objektivlinse zu einer Drehung und damit zusätzlich zu der S-förmigen Verzeichnung. Durch geeignete Wahl der Abgleichkonstanten $\alpha$ lässt sich die S-förmige Verzeichnung kompensieren. In der Regel ist es dazu erforderlich A und $\alpha$ so einzustellen, dass der Teilchenstrahl windschief durch die Objektivlinse hindurchführt, es also keinen Kipppunkt des Teilchenstrahls auf der optischen Achse gibt, sondern nur einen Punkt einer größten Annäherung des Teilchenstrahls an die optische Achse.

Will man dagegen Bilder mit einer möglichst großen Anzahl an Pixel aufnehmen oder Strukturen mit einer großen Pixelzahl schreiben, so ist zu beachten, dass die Anzahl der Pixel, die eine Objektivlinse übertragen kann, ohne dass eine zusätzliche Unschärfe am Bildrand entsteht, die größer als ein Pixel ist, ebenfalls durch Bildfehler begrenzt ist. Zu den hierbei wesentlichen Bildfehlern zählt der außeraxiale Komafehler, der als Schweif sichtbar wird, und die außeraxiale Dispersion, die als Strich sichtbar wird. Bei hinreichend kleiner Wahl der Beleuchtungsapertur sind Bilder mit einer Pixelauflösung von 10 000 x 10 000 Pixel möglich. Es sind aber auch Anwendungen bekannt, bei denen Bildaufnahmen mit 30 000 Pixel x 30000 Pixel wünschenswert sind. Ein Beispiel hierfür ist die Kartografie des Gehirns mit Tausenden von dünnen präparierten Schnitten, die jede für sich mit Tausenden von Bildern mit hoher Pixelzahl dokumentiert werden sollen.

Bei einer rein elektrostatischen Linse treten nur die isotropen Anteile des außeraxialen Komafehlers und der außeraxialen Dispersion auf. Diese Fehler lassen sich durch eine geeignete Wahl des Faktors A minimieren. Bei Verwendung einer magnetischen Objektivlinse oder der Kombination aus einer magnetischen Objektivlinse und einer elektrostatischen Linse treten aber auch anisotrope Anteile des außeraxialen Komafehlers und der außeraxialen Dispersion auf. Diese Aberationen sind senkrecht zur Auslenkrichtung orientiert. Diese Aberationen können deshalb nicht durch geeignete Wahl des Faktors A minimiert werden. Jedoch ist auch eine Korrektur bzw. Minimierung des anisotropen Anteils des außeraxialen Komafehlers und des anisotropen Anteils der außeraxialen Dispersion durch geeignete Wahl der Winkelorientierung der Ablenkfelder möglich. Bei geeigneter Wahl des Werts $\alpha$ für die Winkelorientierung in Abhängigkeit vom eingesetzten Objektiv lassen sich deshalb Bilder mit einer Pixelauflösung von 100000 x 100000 Pixel mit gleicher Schärfe über das gesamte aufgenommene Bildfeld aufnehmen. Entsprechend lassen sich auch bei Lithografieanwendungen Strukturen mit einer entsprechend hohen Pixelzahl schreiben.

Bei konventionellen, nicht bezüglich bestimmter Aberrationen korrigierten Teilchenoptiken sind die axialen Aberationen, (axialer Farbfehler, sphärischer Öffnungsfehler) so groß, dass nur kleine Beleuchtungsaperturen benutzbar sind. Da der außeraxiale Komafehler quadratisch von der Beleuchtungsapertur abhängt, ist dessen Wirkung bei Verwendung konventioneller Teilchenoptiken relativ klein und es ist deshalb möglich, Bildfelder mit 10000 x 10000 Pixel aufzuzeichnen. Wenn jedoch durch Korrektoren die axialen Aberationen korrigierte werden und die Ortsauflösung dadurch weiter verbessert werden soll, ist eine Erhöhung der Beleuchtungsapertur um einen Faktor 3-10 erforderlich. Nur bei solchen größeren Beleuchtungsaperturen wird der Beugungsfehler hinreichen klein. Da bei diesen größeren Beleuchtungsaperturen aber auch der außeraxiale Komafehler um einen Faktor 10 bis 100 größer wird, gewinnt der außeraxiale Komafehler in diesem Fall an Bedeutung. Eine Aufzeichnung von Bildfeldern mit mehr als etwa 1000 x 1000 Pixel ist dann wenig sinnvoll. Durch die geeignete Wahl des Faktors A und der Winkelorientierung $\alpha$ der Ablenkfelder lässt sich sowohl der isotrope als auch der anisotrope Anteil des außeraxialen Komafehlers kompensieren. Dadurch können dann auch bei um einen Faktor 3-10 größeren Beleuchtungsaperturen Bildfelder mit 10000 x 10000 Pixel abgerastert werden und entsprechende Bilder sinnvoll erzeugt werden.

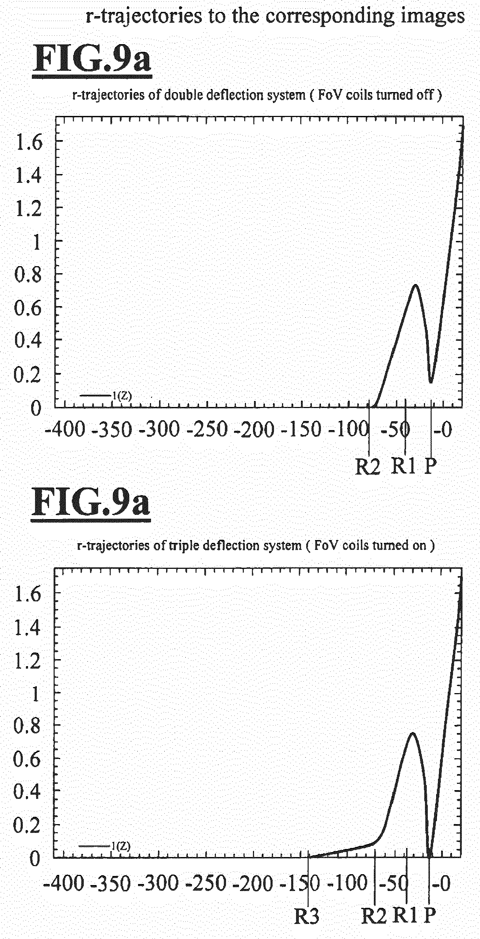

Bei einigen Applikationen, die teilweise bereits weiter oben angesprochen worden sind, ist es sinnvoll, die Probe während des Abrasterns mit dem Teilchenstrahl in einem "schlechten" Vakuum zu halten, um beispielsweise Aufladungen der Probe zu verhindern. Um trotz des relativ hohen Drucks in der Probenkammer die Qualität des Primärteilchenstrahls aufrecht zu erhalten, ist es erforderlich, dass der Teilchenstrahl bis kurz vor der Probe in einem guten Vakuum verläuft, damit nur auf einer möglichst kurzen Strecke Stöße zwischen den Teilchen im Teilchenstrahl und den Molekülen des Restgases auftreten. Dazu ist es üblich, dicht vor der Probe eine Druckstufenblende mit einer kleinen Öffnung einzusetzen und differenziell durch das Objektiv zu pumpen. Je kleiner die Öffnung in der Druckstufenblende ist, desto besser kann in dem Strahlführungsrohr das Vakuum für den Primärteilchenstrahl aufrecht erhalten werden. Die kleine Öffnung in der Druckstufenblende führt aber in der Regel zu einer Beschränkung des in der Objektebene abrasterbaren Bildfelds. Dieses lässt sich bei rein elektrostatischen Objektiven durch Verwendung eines Doppelablenksystems grundsätzlich vermeiden, indem durch entsprechende Ansteuerung des Doppelablenksystems ein virtueller Kipppunkt für den Teilchenstrahl in der Ebene der Druckstufenblende erzeugt wird. Bei Teilchenstrahlgeräten mit magnetischen Objektivlinsen oder teilweisen magnetischen Objektivlinsen führt jedoch die Lamor-Drehung des aus der Objektivlinse austretenden Magnetfelds zu einer zusätzlichen Verdrehung des Bahnverlaufs. Dieses hat zur Folge, dass der vom quellenseitigen Ablenksystem ausgelenkte und vom probenseitigen Ablenksystem zurückgelenkte Teilchenstrahl die optische Achse nicht schneidet, sondern windschief an der optischen Achse vorbei läuft. Dieser Effekt ist in der Figur 9a dargestellt, in der das Ergebnis einer Simulation des radialen Abstands der Trajektorien eines Teilchenstrahls durch ein System mit zwei seriell hintereinander angeordneten Ablenksystemen (R1) und (R2) und einer Magnetlinse dargestellt ist. Das untere Ende des Polschuhs definiert dabei den Nullpunkt der horizontalen Achse in der Figur und die beiden Ablenksysteme sind an den mit (R1) und (R2) bezeichneten Positionen angeordnet. Wie man erkennt, wird der zunächst entlang der optischen Achse (X-Achse) verlaufende Teilchenstrahl durch das quellenseitige Ablenksystem (R2) zunächst von der optischen Achse weggelenkt und nachfolgend durch das objektseitige Ablenksystem (R1) zur optischen Achse zurückgelenkt. Allerdings schneidet die Trajektorie die optische Achse nicht, sondern erreicht einen minimalen Abstand in einem Punkt (P), und anschließend nimmt der radiale Abstand der Teilchenbahn von der optischen Achse wieder zu. Bei dieser Anordnung resultiert zwangsläufig ein Beschnitt des in der Objektebene abrasterbaren Bildfelds.

Da es bei Teilchenstrahlgeräten mit magnetischen Objektivlinsen oder teilweise magnetischen Objektivlinsen durch die Lamor-Drehung des aus der Objektivlinse austretenden Magnetfelds zu einer zusätzlichen Verdrehung des Bahnverlaufs kommen kann, wird beim Umschalten in den "Kippraster-Modus", der nur durch Abschwächung eines Ablenksystems realisiert ist (d.h. nur durch eine Änderung der Größe A), die Teilchensonde auf der Probe nicht stehen bleiben, mit der Folge, dass z.B. bei der Analyse von Kristalleigenschaften die Ergebnisse von verschiedenen Probenstellen vermischt werden. Um dies zu vermeiden, sollte auch hier der Winkelabgleich $\alpha$ zu Hilfe genommen werden.

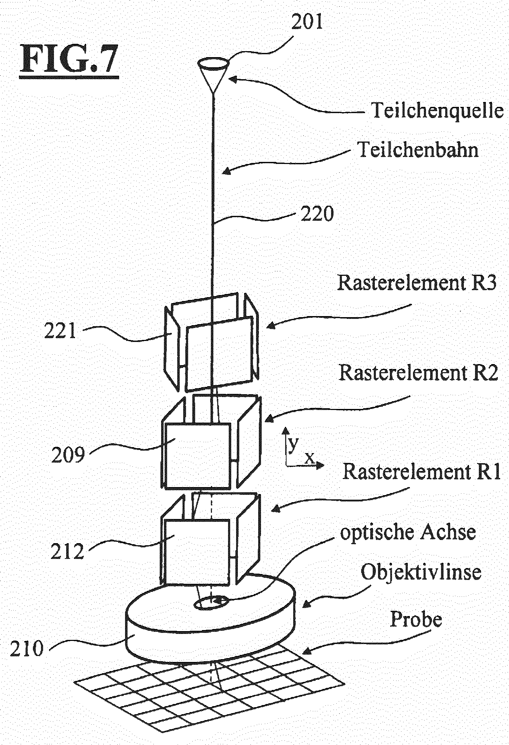

Dieses Problem lässt sich durch eine Anordnung wie in der Figur 7 dargestellt beseitigen. In der Figur 7 ist die Teilchenquelle mit (201) und die Objektivlinse mit (210) bezeichnet. Entlang der optischen Achse sind nun drei gekreuzte Ablenksysteme (209), (212) und (221) seriell hintereinander angeordnet, wobei eines der drei Ablenksysteme, in diesem Fall das quellenseitigste Ablenksystem (221), um die optische Achse (220) verdreht relativ zu den beiden anderen Ablenksystemen (209), (212) angeordnet ist. Da das Ablenksystem (221) gegenüber den Ablenksystemen (209) und (212) um die optische Achse (220) verdreht ist, wird durch das zusätzliche Ablenksystem (221) ein Ablenkfeld erzeugt, dass eine geänderte Winkelorientierung relativ zu den durch die beiden anderen Ablenksystemen (209) und (212) erzeugten Ablenkfeldern aufweist. Durch diesen zusätzlichen Freiheitsgrad der Winkelorientierung bzw. der geänderten Winkelorientierung ist es nun möglich, den Teilchenstrahl so zu führen, dass der Teilchenstrahl die optische Achse schneidet, wie dieses in der Figur 9b dargestellt ist. An der Stelle (P), an der der radiale Abstand der Teilchenbahn von der optischen Achse verschwindet, kann nun eine Druckstufenblende mit einer beliebig kleinen Öffnung angeordnet werden, die zu keinem Beschnitt des mit dem Teilchenstrahl in der Objektebene abrasterbaren Bildfelds führt.

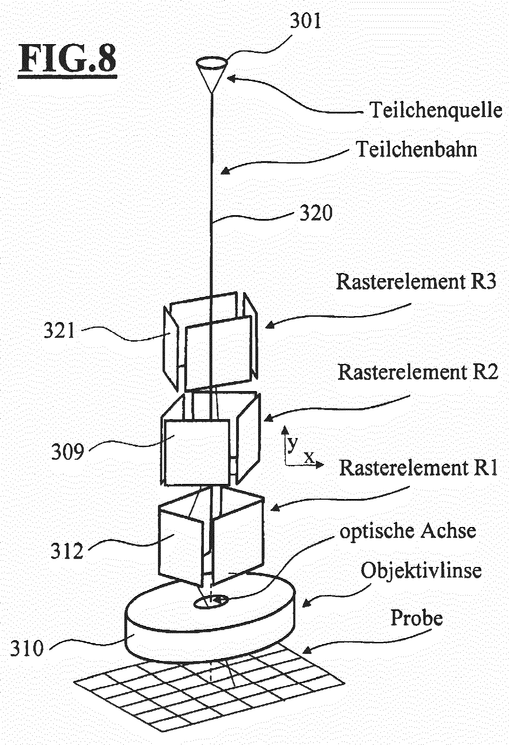

In der Figur 8 ist eine alternative Ausführungsform zu der Ausführungsform in der Figur 7 dargestellt. Wie die Ausführungsform in der Figur 7 weist die Ausführungsform in der Figur 8 drei jeweils gekreuzte Ablenksysteme (309), (312), (321) seriell hintereinander geschaltet entlang der optischen Achse (320) auf, die durch das Objektiv (310) definiert ist. Allerdings sind in diesem Ausführungsbeispiel alle drei Ablenksysteme (309), (312), (321) relativ zueinander um die optische Achse verdreht angeordnet, wobei der relative Drehwinkel zwischen zwei aufeinanderfolgenden Ablenksystemen mindestens 5 Grad, vorzugsweise mehr als 10 Grad und wiederum vorzugsweise mehr als und 20 Grad beträgt.

Wie bereits weiter oben beschrieben, lässt sich derselbe durch gegeneinander verdrehte Ablenksysteme erreichte Effekt auch dadurch erzeugen, wenn nur zwei jeweils gekreuzte Ablenksysteme seriell hintereinander geschaltet sind und die Ansteuerung der Ablenksysteme es erlaubt, Ablenkfelder mit unterschiedlichen Winkelorientierungen zu erzeugen. Dabei liefern die Ausführungsformen mit elektrisch einstellbaren Winkelorientierungen mittels der Bildung nahezu beliebiger Linearkombination der Ablenkfelder noch den Vorteil, dass die Winkelorientierung zwischen den Ablenkfeldern beliebig einstellbar ist. Über die entsprechende stufenlose Einstellung des Faktors A kann man in der Figur 9b den Schnittpunkt des Teilchenstrahls mit der optischen Achse so einstellen, dass das mit dem Teilchenstrahl abrasterbare Bildfeld maximal wird. Dadurch kann man Toleranzen in der Positionierung der Druckstufenblende zum Teil ausgleichen.

Durch eine Veränderung sowohl des Faktors A als auch der Winkelorientierung $\alpha$ während des Betriebs des Teilchenstrahlgeräts ist es möglich, den Abgleich auch in Abhängigkeit von der eingestellten Vergrößerung anzupassen. Bei geringer Vergrößerung ist es sinnvoll, den Faktor A und den Winkelorientierungsfaktor $\alpha$ so einzustellen, dass in der Objektebene ein möglichst großes Bildfeld verzeichnungsarm abrasterbar ist. Bei einer eingestellten höheren Vergrößerung, wenn aufgrund des entsprechend kleineren mit dem Teilchenstrahl abgerasterten Bildfelds die Druckstufenblende das Bildfeld nicht mehr begrenzt, kann der Faktor A und die Winkelorientierung $\alpha$ so gewählt werden, dass die ohne störende Aberationen übertragbare Pixelzahl maximal wird. Dadurch wird erreicht, dass zumindest bei hohen Vergrößerungen auch beim "Variable Pressure"- Betrieb eine ähnlich große Pixelzahl zur Verfügung steht, wie sie auch beim Betrieb des Teilchenstrahlgeräts mit Hochvakuums in der Probenkammer erreichbar ist.

Vorstehend wurde die Erfindung hauptsächlich anhand von Ausführungsbeispielen beschrieben, die zur Erzeugung eines Bilds einer Probe dienen. Die Erfindung ist jedoch gleichermaßen auch bei Teilchenstrahlgeräten einsetzbar, die zur Strukturierung einer Probenoberfläche dienen, da auch bei der Strukturierung von Probenoberflächen häufig unterschiedliche Anforderungen an die Größe des zu strukturierenden Bildfelds, an die Homogenität der Strukturgrößen über das Bildfeld und die bei der Strukturierung erzielte Feinheit der Teilchensonde, die wie die Auflösung beim bilderzeugenden Teilchenstrahlgerät von der Größe der Teilchensonde in der Objektebene bestimmt ist, bestehen.

Mit Hilfe der vorliegenden Erfindung kann das Teilchenstrahlgerät unterschiedliche Betriebsmodi aufweisen, die vom Benutzer auswählbar sind. In jedem der vom Benutzer auswählbaren Betriebsmodi werden für die Ablenkung des Teilchenstrahls in den Ablenksystemen jeweils Winkelorientierungen zwischen den Ablenkfeldern eingestellt bzw. vorgehalten, die zu einer Minimierung desjenigen Abbildungsfehlers führen, der sich bei der jeweiligen Anwendung am stärksten negativ bemerkbar macht. Bei manchen Anwendungen ist es auch möglich, durch geeignete geänderte Wahl der Winkelorientierung zwischen den Ablenkfeldern und/oder der Amplitudenverhältnisse (Faktor A) auf die Summe zweier oder mehr Abbildungsfehler zu optimieren, sodass die Summe der verschiedenen störenden Aberrationen minimal wird.

Zum Auffinden geeigneter Werte für $\alpha$ und A kann man die auftretenden Fehlerwirkungen an einem Bildpunkt beobachten und $\alpha$ und A so lange variieren, bis die störenden Fehlerwirkungen hinreichend klein sind oder die auftretende Bildfeldbeschränkung im gewünschten Umfang reduziert ist. Die so aufgefundenen Werte für $\alpha$ und A werden dann abgespeichert und später bei der Bildaufnahme entsprechend der gewünschten Abbildungsart oder Anwendung entweder manuell oder automatisch entsprechend ausgewählt.

In der Regel gibt es für jeden Betriebsmodus jeweils ein Wertepaar für $\alpha$ und A, das für das gesamte Bildfeld in dem Betriebsmodus angewendet wird, wenn die Objektivlinse rotationssymmetrisch ist.

Bei einer Ausführungsform der Erfindung wird durch nichtlineare Anteile in der Signalgenerierung (43) für die Ablenkelemente eine Kompensation der Verzeichnung vorgehalten. Das hat den Vorteil, dass dann über geeignete Werte für $\alpha$ und A zusätzlich zur Verzeichnung andere vorstehend genannte Abbildungsfehler korrigierbar oder minimierbar sind.

**Patentansprüche**

1. Teilchenstrahlgerät mit

   - einem Teilchenstrahlerzeuger (1),
   - einer Objektivlinse (10) zum Fokussieren eines vom Teilchenstrahlerzeuger erzeugten Teilchenstrahls in einer Objektebene (16), wobei die Objektivlinse eine optische Achse definiert,
   - und einem ersten und einem zweiten Ablenksystem (9, 12) zur Ablenkung des Teilchenstrahls in der Objektebene, wobei das erste und das zweite Ablenksystem seriell hintereinander entlang der optischen Achse angeordnet sind,
   - wobei in einem ersten Betriebsmodus das erste Ablenksystem ein erstes Ablenkfeld (R1) und das zweite Ablenksystem ein zweites Ablenkfeld (R2) erzeugen und das erste und das zweite Ablenkfeld eine erste Winkelorientierung ($\alpha_1$) zu einander aufweisen und so zu einander ausgerichtet sind, dass sie gemeinsam in der Objektebene eine Auslenkung des Teilchenstrahls in einer ersten Richtung ($R_{ges}$) erzeugen,
   - **dadurch gekennzeichnet, dass** in einem zweiten Betriebsmodus das erste Ablenksystem ein drittes Ablenkfeld (R1) und das zweite Ablenksystem ein viertes Ablenkfeld ($R_2$) erzeugen und das dritte und das vierte Ablenkfeld eine zweite Winkelorientierung ($\alpha_2$) zu einander aufweisen und so zu einander ausgerichtet sind, dass sie gemeinsam in der Objektebene eine Auslenkung des Teilchenstrahls in der ersten Richtung erzeugen, und
   - wobei die zweite Winkelorientierung von der ersten Winkelorientierung abweicht.

2. Teilchenstrahlgerät nach Anspruch 1, wobei das dritte Ablenkfeld vom ersten Ablenkfeld und/oder das vierte Ablenkfeld vom zweiten Ablenkfeld abweichen.

3. Teilchenstrahlgerät nach Anspruch 1 oder 2, wobei in einem ersten Betriebsmodus die erste Winkelorientierung so gewählt ist, dass der außeraxiale Komafehler bei der Fokussierung des Teilchenstrahls durch die Objektivlinse minimal ist.

4. Teilchenstrahlgerät nach einem der Ansprüche 1 - 2, wobei in einem ersten Betriebsmodus die erste Winkelorientierung so gewählt ist, dass die gemeinsame Wirkung des außeraxialen Komafehlers und der außeraxialen Dispersion bei der Fokussierung des Teilchenstrahls durch die Objektivlinse minimal ist.

5. Teilchenstrahlgerät nach einem der Ansprüche 1 - 4, wobei in einem zweiten Betriebsmodus die zweite Winkelorientierung so gewählt ist, dass die Verzeichnung bei der Fokussierung des Teilchenstrahls durch die Objektivlinse minimal ist.

6. Teilchenstrahlgerät nach einem der Ansprüche 1 - 5, wobei das Teilchenstrahlgerät einen Engpass im Strahlrohr umfasst und wobei in einem zweiten Betriebsmodus die zweite Winkelorientierung so gewählt ist, dass die Beschneidung des Bildfelds durch den Engpass im Strahlrohr bei der Fokussierung des Teilchenstrahls durch die Objektivlinse minimal ist.

7. Teilchenstrahlgerät nach Anspruch 6, wobei der Engpass die Öffnung einer Druckstufenblende ist.

8. Teilchenstrahlgerät mit

   - einem Teilchenstrahlerzeuger,
   - einer Objektivlinse zum Fokussieren eines vom Teilchenstrahlerzeuger erzeugten Teilchenstrahls in einer Objektebene, wobei die Objektivlinse eine optische Achse definiert,
   - einem ersten, einem zweiten und einem dritten Ablenksystem (209, 212, 221) zur Ablenkung des Teilchenstrahls in der Objektebene, wobei das erste, das zweite und das dritte Ablenksystem seriell hintereinander entlang der optischen Achse angeordnet sind und das erste, das zweite und das dritte Ablenksystem quellenseitig vor der Hauptebene (10) der Objektivlinse angeordnet sind und das erste, zweite und dritte Ablenksystem jeweils Ablenkfelder in zwei Richtungen erzeugen, die weder parallel noch antiparallel zueinander sind.
   - wobei das dritte Ablenksystem (221) relativ zum ersten und zum zweiten Ablenksystem jeweils um mehr als 5° um die optische Achse verdreht angeordnet ist.

9. Teilchenstrahlgerät nach Anspruch 8, wobei das zweite Ablenksystem relativ zum ersten Ablenksystem um mindestens 5° um die optische Achse verdreht angeordnet ist.

10. Teilchenstrahlgerät nach Anspruch 8 oder 9, wobei das dritte Ablenksystem um mindestens 10°, vorzugsweise um mindestens 20°, um die optische Achse verdreht relativ jeweils zum ersten und zum zweiten Ablenksystem angeordnet ist.

11. Teilchenstrahlgerät nach Anspruch 9 oder 10, wobei das zweite Ablenksystem um mindestens 10°, vorzugsweise um mindestens 20°, um die optische Achse verdreht relativ zum ersten Ablenksystem angeordnet ist.

12. Teilchenstrahlgerät nach einem der Ansprüche 8-11, wobei das Teilchenstrahlgerät einen ersten und einem zweiten Betriebsmodus aufweist und eine Umschaltung zwischen dem ersten und zweiten Betriebsmodus durch Einschalten, Ausschalten oder Umpolen des dritten Ablenksystems oder passives Beschalten eines der Ablenksysteme erfolgt.

13. Teilchenstrahlgerät nach Anspruch 12, wobei die Umschaltung zwischen dem ersten und dem zweiten Betriebsmodus bei einer Veränderung der durch die Ablenksysteme in der Objektebene erzeugten maximalen Ablenkung erfolgt.

14. Teilchenstrahlgerät nach einem der Ansprüche 12 bis 13, wobei die Umschaltung zwischen dem ersten und dem zweiten Betriebsmodus in Abhängigkeit von einer Änderung der Beleuchtungsapertur erfolgt.

15. Teilchenstrahlgerät nach einem der Ansprüche 12 bis 14, wobei die Umschaltung zwischen dem ersten und dem zweiten Betriebsmodus in Abhängigkeit davon erfolgt, ob eine maximale Bildgröße oder eine maximale Pixelzahl eines mit Hilfe des Teilchenstrahls aufzunehmenden Bilds oder zu schreibenden Struktur ermöglicht werden soll.

16. Teilchenstrahlgerät nach einem der Ansprüche 11 bis 15, wobei das Teilchenstrahlgerät einen Engpass im Strahlrohr umfasst und wobei die Umschaltung zwischen dem ersten und dem zweiten Betriebsmodus in Abhängigkeit davon erfolgt, ob der zwischen dem ersten, zweiten und dritten Ablenksystem und der Objektebene vorhanden ist.

17. Verfahren zum Betrieb eines Teilchenstrahlgerät mit

   a. einem Teilchenstrahlerzeuger,
   b. einer Objektivlinse zum Fokussieren eines vom Teilchenstrahlerzeuger erzeugten Teilchenstrahls in einer Objektebene, wobei die Objektivlinse eine optische Achse definiert,
   c. und einem ersten und einem zweiten Ablenksystem zur Ablenkung des Teilchenstrahls in der Objektebene, wobei das erste und das zweite Ablenksystem seriell hintereinander entlang der optischen Achse angeordnet sind,
   d. wobei in einem ersten Betriebsmodus das erste Ablenksystem ein erstes Ablenkfeld und das zweite Ablenksystem ein zweites Ablenkfeld erzeugen und das erste und das zweite Ablenkfeld eine erste Winkelorientierung zu einander aufweisen und so zu einander ausgerichtet sind, dass sie gemeinsam in der Objektebene eine Auslenkung des Teilchenstrahls in einer ersten Richtung erzeugen,

e. wobei in einem zweiten Betriebsmodus das erste Ablenksystem ein drittes Ablenkfeld und das zweite Ablenksystem ein viertes Ablenkfeld erzeugen und das dritte und das vierte Ablenkfeld eine zweite Winkelorientierung zu einander aufweisen und so zu einander ausgerichtet sind, dass sie gemeinsam in der Objektebene eine Auslenkung des Teilchenstrahls in der ersten Richtung erzeugen,

f. wobei die zweite Winkelorientierung von der ersten Winkelorientierung abweicht, und

g. wobei der Wechsel zwischen dem ersten und dem zweiten Betriebsmodus während des Betriebs des Teilchenstrahlgeräts erfolgt.

**Claims**

1. Particle beam device comprising

   - a particle beam generator (1),
   - an objective lens (10) for focusing a particle beam generated by the particle beam generator in an object plane (16), wherein the objective lens defines an optical axis,
   - and a first and a second deflection system (9, 12) for deflecting the particle beam in the object plane, wherein the first and the second deflection system are arranged serially one behind the other along the optical axis,
   - wherein, in a first operating mode, the first deflection system generates a first deflection field (R1) and the second deflection system generates a second deflection field (R2) and the first and the second deflection field have a first angular orientation ($\alpha_1$) with respect to one another and are aligned with respect to one another such that they jointly produce in the object plane a deflection of the particle beam in a first direction ($R_{tot}$),
   - **characterized in that**, in a second operating mode, the first deflection system generates a third deflection field (R1) and the second deflection system generates a fourth deflection field (R2) and the third and the fourth deflection field have a second angular orientation ($\alpha_2$) with respect to one another and are aligned with respect to one another such that they jointly produce in the object plane a deflection of the particle beam in the first direction, and
   - wherein the second angular orientation deviates from the first angular orientation.

2. Particle beam device according to Claim 1, wherein the third deflection field deviates from the first deflection field and/or the fourth deflection field deviates from the second deflection field.

3. Particle beam device according to Claim 1 or 2, wherein, in a first operating mode, the first angular orientation is chosen such that the off-axis coma aberration during the focusing of the particle beam by the objective lens is minimal.

4. Particle beam device according to either of Claims 1-2, wherein, in a first operating mode, the first angular orientation is chosen such that the common effect of the off-axis coma aberration and of the off-axis dispersion during the focusing of the particle beam by the objective lens is minimal.

5. Particle beam device according to any of Claims 1-4, wherein, in a second operating mode, the second angular orientation is chosen such that the distortion during the focusing of the particle beam by the objective lens is minimal.

6. Particle beam device according to any of Claims 1-5, wherein the particle beam device comprises a bottleneck in the beam tube and wherein, in a second operating mode, the second angular orientation is chosen such that the trimming of the image field by the bottleneck in the beam tube during the focusing of the particle beam by the objective lens is minimal.

7. Particle beam device according to Claim 6, wherein the bottleneck is the opening of a pressure stage aperture.

8. Particle beam device comprising

   - a particle beam generator,
   - an objective lens for focusing a particle beam generated by the particle beam generator in an object plane, wherein the objective lens defines an optical axis,
   - a first, a second and a third deflection system (209, 212, 221) for deflecting the particle beam in the object plane, wherein the first, the second and the third deflection system are arranged serially one behind another along the optical axis and the first, the second and the third deflection system are arranged on the source side upstream of the principal plane (10) of the objective lens and the first, second and third deflection systems in each case generate deflection fields in two directions which are neither parallel nor antiparallel to one another, - wherein the third deflection system (221) is arranged in a manner rotated about the optical axis in each case by more than 5° relative to the first and to the second deflection system.

9. Particle beam device according to Claim 8, wherein the second deflection system is arranged in a manner rotated about the optical axis by at least 5° relative to the first deflection system.

10. Particle beam device according to Claim 8 or 9, wherein the third deflection system is arranged in a manner rotated about the optical axis by at least 10°, preferably by at least 20°, relative in each case to the first and to the second deflection system.

11. Particle beam device according to Claim 9 or 10, wherein the second deflection system is arranged in a manner rotated about the optical axis by at least 10°, preferably by at least 20°, relative to the first deflection system.

12. Particle beam device according to any of Claims 8-11, wherein the particle beam device has a first and a second operating mode and a changeover between the first and second operating modes is effected by switching on, switching off or reversing the polarity of the third deflection system or passively connecting up one of the deflection systems.

13. Particle beam device according to Claim 12, wherein the changeover between the first and the second operating mode is effected in the case of a change in the maximum deflection produced by the deflection systems in the object plane.

14. Particle beam device according to either of Claims 12 to 13, wherein the changeover between the first and the second operating mode is effected in a manner dependent on a change in the illumination aperture.

15. Particle beam device according to any of Claims 12 to 14, wherein the changeover between the first and the second operating mode is effected in a manner dependent on whether a maximum image size or a maximum number of pixels of an image to be recorded with the aid of the particle beam or structure to be written is to be permitted.

16. Particle beam device according to any of Claims 11 to 15, wherein the particle beam device comprises a bottleneck in the beam tube and wherein the changeover between the first and the second operating mode is effected in a manner dependent on whether said bottleneck is present between the first, second and third deflection systems and the object plane.

17. Method for operating a particle beam device comprising

a. a particle beam generator,
b. an objective lens for focusing a particle beam generated by the particle beam generator in an object plane, wherein the objective lens defines an optical axis,
c. and a first and a second deflection system for deflecting the particle beam in the object plane, wherein the first and the second deflection system are arranged serially one behind the other along the optical axis,
d. wherein, in a first operating mode, the first deflection system generates a first deflection field and the second deflection system generates a second deflection field and the first and the second deflection field have a first angular orientation with respect to one another and are aligned with respect to one another such that they jointly produce in the object plane a deflection of the particle beam in a first direction,
e. wherein, in a second operating mode, the first deflection system generates a third deflection field and the second deflection system generates a fourth deflection field and the third and the fourth deflection field have a second angular orientation with respect to one another and are aligned with respect to one another such that they jointly produce in the object plane a deflection of the particle beam in the first direction,
f. wherein the second angular orientation deviates from the first angular orientation, and
g. wherein the change between the first and the second operating mode is effected during the operation of the particle beam device.

**Revendications**

1. Appareil de rayonnement de particules comprenant

   - un générateur de rayonnement de particules (1),
   - une lentille d'objectif (10) destinée à concentrer un rayonnement de particules généré par le générateur de rayonnement de particules dans un plan d'objet (16), la lentille d'objectif définissant un axe optique,
   - et un premier ainsi qu'un deuxième système de déviation (9, 12) destinés à dévier le rayonnement de particules dans le plan d'objet, le premier et le deuxième système de déviation étant disposés en série l'un derrière l'autre le long de l'axe optique,
   - dans un premier mode de fonctionnement, le premier système de déviation générant un premier champ de déviation (R1) et le deuxième système de déviation un deuxième champ de déviation (R2), et les premier et deuxième champs de déviation présentant une première orientation angulaire ($\alpha_1$) l'un par rapport à l'autre et étant orientés l'un par rapport à l'autre de telle sorte qu'ils génèrent ensemble, dans le plan d'objet, une déviation du rayonnement de particules dans une première direction ($R_{ges}$),
   - **caractérisé en ce que** dans un deuxième mode de fonctionnement, le premier système de déviation génère un troisième champ de déviation (R1) et le deuxième système de déviation un quatrième champ de déviation (R2), et les troisième et quatrième champs de déviation présentent une deuxième orientation angulaire ($\alpha_2$) l'un par rapport à l'autre et sont orientés l'un par rapport à l'autre de telle sorte qu'ils génèrent ensemble, dans le plan d'objet, une déviation du rayonnement de particules dans la première direction, et
   - la deuxième orientation angulaire étant différente de la première orientation angulaire.

2. Appareil de rayonnement de particules selon la revendication 1, le troisième champ de déviation étant différent du premier champ de déviation et/ou le quatrième champ de déviation du deuxième champ de déviation.

3. Appareil de rayonnement de particules selon la revendication 1 ou 2, la première orientation angulaire étant choisie dans un premier mode de fonctionnement de telle sorte que l'erreur d'aberration en coma extra-axiale lors de la concentration du rayonnement de particules par la lentille d'objectif est minimale.

4. Appareil de rayonnement de particules selon l'une des revendications 1 à 2, la première orientation angulaire étant choisie dans un premier mode de fonctionnement de telle sorte que l'effet commun de l'erreur d'aberration en coma extra-axiale et de la dispersion extra-axiale lors de la concentration du rayonnement de particules par la lentille d'objectif soit minimal.

5. Appareil de rayonnement de particules selon l'une des revendications 1 à 4, la deuxième orientation angulaire étant choisie dans un deuxième mode de fonctionnement de telle sorte que la distorsion lors de la concentration du rayonnement de particules par la lentille d'objectif soit minimale.

6. Appareil de rayonnement de particules selon l'une des revendications 1 à 5, l'appareil de rayonnement de particules comprenant un passage étroit dans le tube de rayonnement et la deuxième orientation angulaire étant choisie dans un deuxième mode de fonctionnement de telle sorte que le rognage du champ d'image par le passage étroit dans le tube de rayonnement lors de la concentration du rayonnement de particules par la lentille d'objectif soit minimal.

7. Appareil de rayonnement de particules selon la revendication 6, le passage étroit étant l'ouverture d'un diaphragme à niveaux de pression.

8. Appareil de rayonnement de particules comprenant

   - un générateur de rayonnement de particules,
   - une lentille d'objectif destinée à concentrer un rayonnement de particules généré par le générateur de rayonnement de particules dans un plan d'objet, la lentille d'objectif définissant un axe optique,
   - un premier, un deuxième et un troisième système de déviation (209, 212, 221) destinés à dévier le rayonnement de particules dans le plan d'objet, le premier, le deuxième et le troisième système de déviation étant disposés en série l'un derrière l'autre le long de l'axe optique et le premier, le deuxième et le troisième système de déviation étant disposés du côté de la source devant le plan principal (10) de la lentille d'objectif, et
   - le premier, le deuxième et le troisième système de déviation générant respectivement des champs de déviation dans deux directions qui ne sont ni parallèles ni antiparallèles l'une à l'autre,
   - le troisième système de déviation (221) étant disposé par rapport au premier et au deuxième système de déviation en étant respectivement décalé de plus de 5° autour de l'axe optique.

9. Appareil de rayonnement de particules selon la revendication 8, le deuxième système de déviation étant disposé par rapport au premier système de déviation en étant décalé d'au moins 5° autour de l'axe optique.

10. Appareil de rayonnement de particules selon la revendication 8 ou 9, le troisième système de déviation étant disposé en étant tourné d'au moins 10°, de préférence d'au moins 20° autour de l'axe optique respectivement par rapport au premier et au deuxième système de déviation.

11. Appareil de rayonnement de particules selon la revendication 9 ou 10, le deuxième système de déviation étant disposé en étant tourné d'au moins 10°, de préférence d'au moins 20° autour de l'axe optique par rapport au premier système de déviation.

12. Appareil de rayonnement de particules selon l'une des revendications 8 à 11, l'appareil de rayonnement de particules possédant un premier et un deuxième mode de fonctionnement, et une permutation entre le premier et le deuxième mode de fonctionnement étant effectuée par la mise en circuit, la mise hors circuit ou l'inversion de polarité du troisième système de déviation ou la connexion passive de l'un des systèmes de déviation.

13. Appareil de rayonnement de particules selon la revendication 12, la permutation entre le premier et le deuxième mode de fonctionnement étant effectuée lors d'une modification de la déviation maximale générée dans le plan d'objet par les systèmes de déviation.

14. Appareil de rayonnement de particules selon l'une des revendications 12 à 13, la permutation entre le premier et le deuxième mode de fonctionnement étant effectuée en fonction d'une modification de l'ouverture d'éclairage.

15. Appareil de rayonnement de particules selon l'une des revendications 12 à 14, la permutation entre le premier et le deuxième mode de fonctionnement étant effectuée suivant qu'il faille rendre possible une taille d'image maximale ou un nombre de pixels maximal d'une image à enregistrer ou d'une structure à décrire à l'aide du faisceau de particules.

16. Appareil de rayonnement de particules selon l'une des revendications 11 à 15, l'appareil de rayonnement de particules comprenant un passage étroit dans le tube de rayonnement et la permutation entre le premier et le deuxième mode de fonctionnement étant effectuée suivant que celui-ci se trouve entre le premier, le deuxième et le troisième système de déviation et le plan d'objet.

17. Procédé pour faire fonctionner un appareil de rayonnement de particules, comprenant

a. un générateur de rayonnement de particules,
b. une lentille d'objectif destinée à concentrer un rayonnement de particules généré par le générateur de rayonnement de particules dans un plan d'objet, la lentille d'objectif définissant un axe optique,
c. et un premier ainsi qu'un deuxième système de déviation destinés à dévier le rayonnement de particules dans le plan d'objet, le premier et le deuxième système de déviation étant disposés en série l'un derrière l'autre le long de l'axe optique,
d. dans un premier mode de fonctionnement, le premier système de déviation générant un premier champ de déviation et le deuxième système de déviation un deuxième champ de déviation, et les premier et deuxième champs de déviation présentant une première orientation angulaire l'un par rapport à l'autre et étant orientés l'un par rapport à l'autre de telle sorte qu'ils génèrent ensemble, dans le plan d'objet, une déviation du rayonnement de particules dans une première direction,
e. dans un deuxième mode de fonctionnement, le premier système de déviation générant un troisième champ de déviation et le deuxième système de déviation un quatrième champ de déviation, et les troisième et quatrième champs de déviation présentant une deuxième orientation angulaire l'un par rapport à l'autre et étant orientés l'un par rapport à l'autre de telle sorte qu'ils génèrent ensemble, dans le plan d'objet, une déviation du rayonnement de particules dans la première direction,
f. la deuxième orientation angulaire étant différente de la première orientation angulaire, et
g. le changement entre le premier et le deuxième mode de fonctionnement s'effectuant pendant le fonctionnement de l'appareil de rayonnement de particules.

FIG.1

## FIG.2b

## FIG.2a

FIG.3

FIG.4

FIG.5

**FIG.6**

101 — Teilchenquelle

Teilchenbahn

Rasterelement R2

109

112

Rasterelement R1

optische Achse

Objektivlinse

Probe

110

116

FIG.7

201 — Teilchenquelle

Teilchenbahn

220

221 — Rasterelement R3

209 — Rasterelement R2

Rasterelement R1

212 — optische Achse

Objektivlinse

210 — Probe

FIG.8

301 — Teilchenquelle

Teilchenbahn

320

321

Rasterelement R3

309

Rasterelement R2

Rasterelement R1

312

optische Achse

Objektivlinse

310

Probe

r-trajectories to the corresponding images

# FIG.9a

r-trajectories of double deflection system ( FoV coils turned off )

# FIG.9a

r-trajectories of triple deflection system ( FoV coils turned on )

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6809322 B
- US 20080142723 A1